(19) Europäisches Patentamt

European Patent Office

Office européen des brevets

(11) Publication number: **0 689 283 A1**

## (12) EUROPEAN PATENT APPLICATION

(21) Application number: 95303867.6

(22) Date of filing: 06.06.95

(51) Int. Cl.⁶: **H03B 5/12**, H03B 5/20, H03B 7/06, G06G 7/186, H03F 1/14

(30) Priority: 24.06.94 GB 9412787

(43) Date of publication of application:
27.12.95 Bulletin 95/52

(84) Designated Contracting States:
AT DE ES FR GB IT NL

(71) Applicant: **PLESSEY SEMICONDUCTORS LIMITED**
**Cheney Manor**
**Swindon,**
**Wiltshire SN2 2OW (GB)**

(72) Inventor: **Madni, Arshad**
**17 Priory Road, South Park**
**Swindon SN3 2HA (GB)**

(74) Representative: **Hoste, Colin Francis**
**The General Electric Company p.l.c.**
**GEC Patent Department**
**Waterhouse Lane**
**Chelmsford, Essex CM1 2OX (GB)**

(54) **Tunable oscillator arrangement**

(57) In a tunable oscillator arrangement, a frequency-determining element, e.g. a capacitor, which is part of a tank circuit associated with an active oscillator stage, is connected between an input and output of a gain-controlled amplifier, the inductor of the tank circuit being connected across the inputs of the amplifier. Advantage is taken of the Miller effect to bring about changes in effective capacitance appearing across the inputs of the amplifier in response to changes in a DC gain-control signal applied to the amplifier, these changes in capacitance in turn varying the resonant frequency of the tank circuit.

Figure 1

EP 0 689 283 A1

The invention concerns a tunable oscillator arrangement, and in particular, but not exclusively, a tunable oscillator arrangement for use in integrated circuits.

Tunable oscillators up to now have used varactor diodes or charge-pump techniques to achieve frequency control. A disadvantage with varactor-diode arrangements is that they are bulky and require high-voltage (nominally 30V) drive circuitry, which makes on-chip frequency control difficult. While charge-pump methods do not require the provision of such high voltages, they have the drawback that they do not provide for low-noise oscillator outputs, and they tend to be associated with non-linearities in the output waveform.

It would be desirable to provide a tunable oscillator arrangement which overcomes or mitigates the drawbacks associated with the known frequency-control techniques.

In accordance with the invention, there is provided a tunable oscillator arrangement, comprising a frequency-determining means and a tuning amplifier, the frequency-determining means comprising a frequency-determining element which is connected between an input and an output of the tuning amplifier, whereby an operating frequency of the oscillator arrangement is adjustable by an adjustment of the gain of the tuning amplifier.

Configuring the frequency-determining element in this way makes use of the Miller effect in an amplifier and allows the value of that element, and hence the frequency of operation of an oscillator of which the frequency-determining element forms a part, to be varied simply by varying the gain of the amplifier.

The frequency-determining element will normally be a capacitor in a tank circuit, but it may alternatively be an inductor in such a tank circuit or a resistor or a capacitor in some other frequency-determining arrangement (e.g. an inductorless phase-shifting network).

Where the frequency-determining element is a capacitor in a tank circuit, the operating frequency of an oscillator of which the tank circuit forms a part is given by the following relationship:

$$f = \frac{1}{2\pi \sqrt{LC(1+A)}}$$

where L and C are values of the inductance and capacitance in the tank circuit and A is the gain of the amplifier. Thus it can be seen that the Miller effect multiplies the value of a capacitor connected across an amplifier by a factor (1 + A).

The tuning amplifier may comprise a tuning differential amplifier stage with differential inputs and outputs, and the frequency-determining means may comprise two capacitors, the capacitors being connected between separate inputs and outputs of the tuning differential amplifier stage.

Where the frequency-determining means is a tank circuit, the inductive element in the tank circuit may be coupled across the differential inputs of the tuning differential amplifier stage.

A negative impedance converter may be connected in series with a tail circuit of the tuning differential amplifier stage. The negative impedance converter may comprise two transistors cross-coupled from collector to base, a first resistive element being connected between the two emitters of the transistors, and the respective emitters and collectors of the transistors providing respective conduction paths for tail currents of respective halves of the tuning differential amplifier stage.

The effect of such a negative impedance converter (NIC) in the tail circuit of the tuning differential amplifier stage is to introduce a negative resistance, proportional to the value of the resistive element between the emitters of the NIC, into the tails of the tuning stage. This negative resistance reduces the normal emitter resistance ($r_E$) of the tuning differential amplifier stage and reduces, therefore, the normal temperature-dependence of the stage due to that emitter resistance.

A gain-adjusting means may be included in an output circuit of the tuning differential amplifier stage. The gain-adjusting means may be arranged to steer output current from each half of the tuning differential amplifier stage into either or both of two tuning load-impedance elements, such as to provide a tuning amplifier gain of variable magnitude and sign, depending on a gain-control voltage applied to the gain-adjusting means.

The gain-adjusting means may be a multiplier comprising two long-tailed pairs of transistors, the pairs of transistors being fed in parallel from two differential gain-control inputs, the collectors of the two halves of one pair of transistors being connected respectively to the collectors of the oppositely fed halves of the other pair of transistors and to respective load-impedance elements, and the long-tailed pairs each having commoned emitters which serve to supply the output current of a respective half of the tuning differential amplifier stage.

Such a multiplier is commonly known as a 4-quadrant Gilbert multiplier and, being a differential arrangement, ensures that the current-sharing, and hence gain control, only occurs in response to differential gain-control signals. Thus, gain control is made insensitive to processing variations in the chip of which the oscillator arrangement is intended to form a part.

The gain of the multiplier is capable of being varied from + 1 to -1 in dependence on the gain-control voltage applied to its inputs. This gives the tuning amplifier the ability to function either as an inverting amplifier, which is the normal mode for a Miller application, or as a non-inverting amplifier. When the amplifier functions in an inverting mode, the gain term ("A") in the above equation is negative, and therefore, as the modulus of the gain increases, the effective Miller capacitance likewise increases and the frequency of the oscillator arrangement decreases, reaching a minimum at maximum negative gain.

When the amplifier is in non-inverting mode, however, the gain term is positive and, provided gain is kept to less than unity, the effective Miller capacitance will decrease from the natural capacitance value, C, towards zero, thereby causing a corresponding increase in operating frequency of the oscillator arrangement.

The differential gain-control inputs of the multiplier may be fed from respective differential outputs of a controlling differential amplifier stage, the outputs of the controlling differential amplifier stage being connected to respective diode elements which serve as controlling load-impedance elements, and the controlling differential amplifier stage having differential inputs for receiving the gain-control voltage.

The use of two diode elements, which may be realised as two diode-connected transistors, in this way provides for a so-called pre-distortion circuit which helps to linearise the operation of the multiplier.

The tuning differential amplifier stage may have differential outputs which are taken from the respective tuning load-impedance elements by way of respective voltage followers, the voltage followers providing a low-output-impedance drive for the capacitors of the frequency-determining means.

The frequency-determining means may be part of an active oscillator stage. The active oscillator stage may comprise an oscillator differential amplifier stage, and, where the frequency-determining means is a tank circuit, the inductive element may be connected across differential inputs of the oscillator differential amplifier stage. Also, the non-inverting outputs of the oscillator differential amplifier stage may be connected to respective inputs of the tuning differential amplifier stage.

The oscillator differential amplifier stage may comprise an oscillator bipolar-transistor long-tailed pair and a linearising means for substantially cancelling distortions which arise in the oscillator long-tailed pair.

The linearising means may comprise first, second and third linearising bipolar-transistor long-tailed pairs, the collectors of respective halves of the linearising long-tailed pairs being connected together and to respective bases of the oscillator long-tailed pair, and the bases of each linearising long-tailed pair being connected to respective emitters of the oscillator long-tailed pair, such that the first and third linearising long-tailed pair are driven in phase with each other and in antiphase with the second linearising long-tailed pair.

The bases of the third linearising long-tailed pair may be connected to each other by way of a second resistive element and to respective emitters of the oscillator long-tailed pair by way of third and fourth resistive elements. The tail currents of the oscillator long-tailed pair and the respective tail currents of the first, second and third linearising long-tailed pairs may be provided by respective current sources.

The linearising means may be arranged to compensate for a cubic nonlinearity which arises due to an exponential nature of a base-emitter characteristic of the transistors of the oscillator long-tailed pair. Without such a linearising arrangement, the output of the active oscillator stage may contain unacceptably high harmonics.

The third and fourth resistive elements may be of substantially equal resistance value and may be approximately 1/4.88 times the resistance value of the second resistive element, and the tail current provided by each of the oscillator long-tailed pair current sources and by the second linearising long-tailed pair current source may be approximately equal to 4.23 times, and the tail current provided by the third linearising long-tailed pair current source approximately equal to 1.41 times, the tail current provided by the first linearising long-tailed pair current source.

The invention will now be described, by way of example only, with reference to the drawings, of which:

Figure 1 is a circuit diagram showing the main features of an embodiment of the tunable oscillator arrangement according to the invention;

Figures 2 and 3 are a more detailed circuit diagram of a preferred embodiment of the oscillator arrangement of Figure 1;

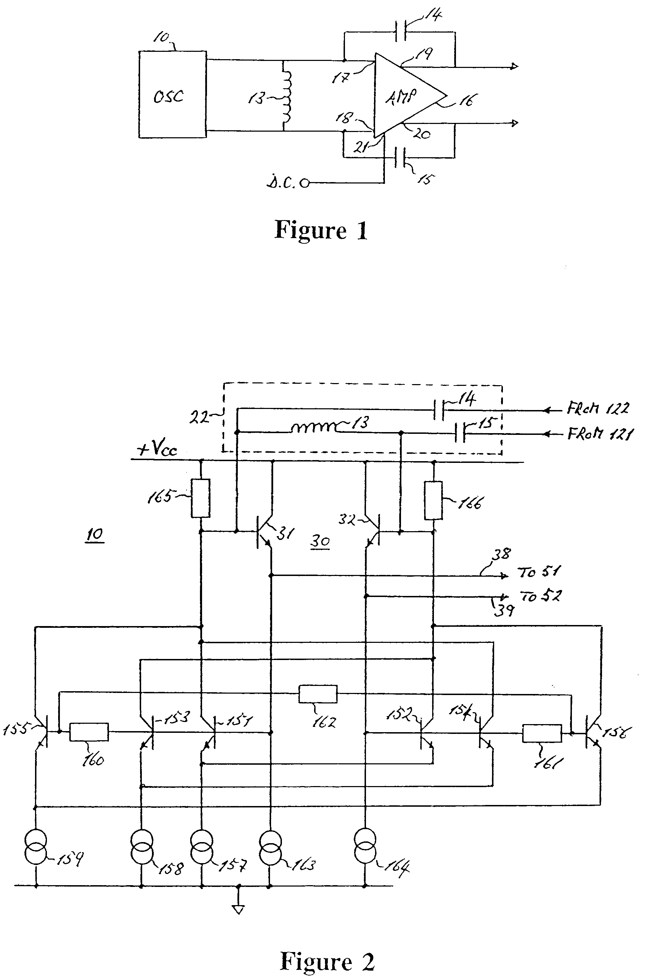

Referring now to Figure 1, in Figure 1 an oscillator stage 10 has its operating frequency determined by a tank circuit consisting of an inductor 13 and two capacitors 14 and 15. The inductor 13 is connected across the differential inputs of an amplifier 16, and the capacitors 14 and 15 are each connected between an input 17, 18 and an output 19, 20 of the amplifier 16, which is a differential-input, differential-output amplifier. The gain of the amplifier 16 is adjusted by applying a variable DC voltage to a gain-control input 21, and this change in gain brings about a corresponding change in the effective (Miller) value of the capacitors 14, 15.

Thus, the resonant frequency of the tank circuit is altered and the operating frequency of the oscillator 10 is suitably adjusted.

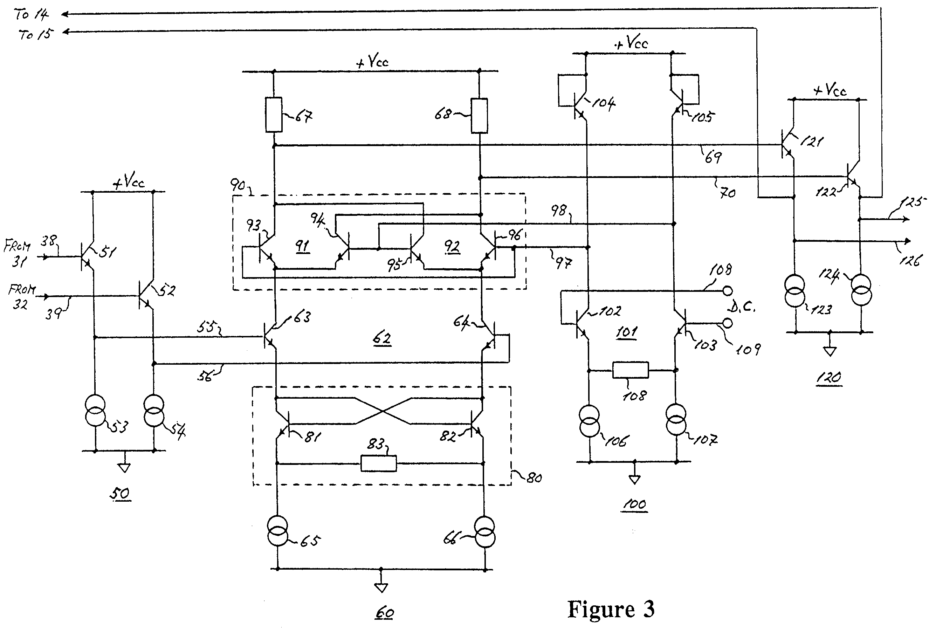

The various sections of the arrangement shown in Figure 1 are shown in greater detail in Figures 2 and 3. Thus, the oscillator stage 10 of Figure 1 is shown in Figure 2 as a modified Wilson oscillator based around an oscillator differential amplifier stage 30. The modification consists in the provision of linearising circuitry for cancelling out distortions present in the differential amplifier 30.

The oscillator differential amplifier stage 30 is configured as an emitter follower stage comprising two transistors 31, 32. Between the two bases of the transistors 31, 32 is connected an inductor 13, which is part of a tank circuit 22, and connected to respective ends of the inductor 13 are two capacitors 14, 15, also part of the tank circuit 22. The required cross-coupling between inputs and outputs of the transistors 31, 32, together with the desired linearising compensation, is provided by the linearising long-tailed pairs comprising transistors 151 and 152, 153 and 154, 155 and 156. The linearising long-tailed pairs are driven in parallel at their respective bases from the emitters of transistors 31, 32 of the oscillator differential amplifier 30, with transistors 155, 156 being driven through respective resistors 160, 161. The bases of transistors 155 and 156 are connected together through a resistor 162. The collectors of transistors 151, 154 and 155 are taken to the base of transistor 31, while the collectors of transistors 152, 153 and 156 are taken to the base of transistor 32. The tail currents of the linearising long-tailed pairs are set by respective current sources 157, 158, 159, while those of the differential amplifier 30 are set by current sources 163 and 164.

The linearising arrangement in the preferred embodiment of Figure 2 is designed to effect compensation for a cubic distortion present in the basic amplifier stage 30, and it is this requirement which determines the current ratios of the current sources 157, 158 and 159 and the resistance ratios of the resistors 160, 161 and 162.

The emitter-follower outputs of the oscillator differential amplifier 30 are taken along lines 38, 39 to the inputs of a level-shifter stage 50, shown in Figure 2. The level-shifter stage 50 comprises two emitter-followers 51, 52, the output current of each of which is set by a respective current source 53, 54.

The outputs of the emitter followers 51, 52 are taken along lines 55 and 56 to respective inputs of a tuning stage 60. The tuning stage 60 is based around a tuning differential amplifier stage 62 comprising two bipolar transistors 63, 64 having tail currents set by current sources 65, 66. The output signals of the tuning differential amplifier stage 62 are developed across respective load-impedance elements constituted by resistors 67 and 68. The outputs of the tuning differential amplifier stage 62 are taken along lines 69 and 70 to the inputs of an output driver stage 120. Output driver stage 120 takes the same form as the level-shifter stage 50 and is based around emitter-follower transistors 121, 122 with current sources 123, 124. The emitter outputs of the output stage 120 feed both the output terminals 125, 126 of the tunable oscillator arrangement and also the tank-circuit capacitors 14, 15, which are returned to respective inputs of the oscillator differential amplifier stage 30 (see Figure 2).

In order to reduce the dependency of the tuning amplifier 60 on temperature, a negative impedance converter 80 is included in the tail circuit of the tuning differential amplifier stage 62. This negative impedance converter 80 comprises two transistors 81, 82, which are cross-coupled at their bases and collectors, and a resistor 83 connected between the emitters of the transistors 81, 82. The converter presents a resistance corresponding to the negative of the resistance of resistor 83 to the emitters of transistors 63 and 64. This negative resistance serves to reduce the effective emitter resistance, $r_E$, of the transistors 63, 64, thereby reducing the temperature-dependence of the tuning amplifier stage.

The gain of the tuning amplifier stage 60 is adjusted with the aid of a multiplier circuit 90 situated in the output circuit of the tuning stage 60. The multiplier 90 comprises two long-tailed pairs 91, 92, consisting respectively of transistors 93 and 94, 95 and 96. The emitters of pair 91 are taken to the collector of transistor 63, while the emitters of pair 92 are taken to the collector of transistor 64. The long-tailed pairs 91 and 92 are driven in parallel at their bases along lines 97 and 98, and the collectors of transistors 93 and 95 are taken to the load resistor 67, while the collectors of transistors 94 and 96 are taken to the load resistor 68.

The drive signals for the gain-determining multiplier circuit 90 are provided by a control signal driver stage 100. The control signal driver stage 100 consists of a controlling long-tailed pair 101 which comprises transistors 102 and 103. The collectors of transistors 102, 103 are connected to respective load impedance elements, as constituted by a pair of diode-connected transistors 104, 105, and the long-tailed pair 101 has tail currents determined by current sources 106, 107. An emitter resistance 108 is connected between the emitters of the transistors 102, 103. The differential gain-control signals on the lines 97, 98 are developed across the diode loads 104, 105, and gain control is effected by the application of a DC voltage on the terminals 108, 109, which are connected to respective bases of the long-tailed pair 101.

In operation, depending on the sense of the input gain-control signal on terminals 108 109, one half of each multiplier long-tailed pair 91, 92 will conduct more current than the other half, the total current for each pair being determined by the current sources 65 and 66. When the differential gain-control input on terminals 108, 109 is zero, there will be substantially equal sharing between the two halves of each multiplier long-tailed pair 91, 92 and, since the halves are driven in antiphase along the lines 97, 98, the resultant signal current through each of the resistors 67, 68 will be zero. This corresponds to zero gain of the tuning stage 60, with the result that the capacitors 14 and 15 do not undergo Miller multiplication, but remain at their own natural value. When, however, the potential on line 98, say, is more positive than that on line 97, transistors 94 and 95 conduct more than transistors 93 and 96 and the resistance 68 has developed across it a net load signal associated with transistor 63, resistance 67 a net load signal associated with transistor 64. This puts the tuning amplifier into an inverting-amplifier mode, since the tank signals on the bases of transistors 31 and 32 in the oscillator stage 10 are not inverted on their way to the inputs of the tuning long-tailed pair 62. Thus, as the differential gain-control input on the terminals 108, 109 continues to rise according to this polarisation, the inverting gain of the tuning stage 60 increases and the effective Miller capacitance of the capacitors 14 and 15 likewise increases. The result is a decrease in the operating frequency of the oscillator 10.

On the other hand, when the potential on the gain-control line 98 is more negative than that on line 97, the situation is reversed, with resistance 67 producing a net output signal associated with transistor 63 and resistance 68 a net signal associated with transistor 64. This places the tuning amplifier 60 in a non-inverting mode, with the result that, as the differential gain-control input on the terminals 108, 109 increases in this now opposite sense, the non-inverting gain rises and therefore the effective Miller capacitance of the capacitors 14 and 15 decreases below its natural value. The upshot is an increased frequency of operation of the oscillator stage 10. Clearly, care must be taken with this mode of operation, as instability may result if the non-inverting gain of the tuning stage 60 is taken too high.

In order to ensure linear control of the Miller capacitance, the load resistances and current sources of the oscillator stage and tuning stage are chosen so that the signal amplitude on the lines 38 and 39 of the oscillator stage is much less than the signal amplitude on the tuning stage output lines 69, 70. This requires that the following inequality be observed: $I_{65}$, $I_{66} \times R_{67}$, $R_{68} \gg I_{163}$, $I_{164} \times R_{165}$, $R_{166}$.

While the tunable oscillator arrangement according to the invention has been described specifically in terms of Miller capacitance, other arrangements may be envisaged in which other, non-capacitive, components of a frequency-determining means are connected across the tuning amplifier, i.e. one or more resistors or inductors. In these cases, however, the effect of an increase in, say, the inverting gain of the tuning stage 60 will be the opposite of the effect of such an increase when a capacitor is being used as the Miller element. Thus, where a resistor or an inductor is fed back from output to input of the amplifier, the resulting change in effective resistance/inductance value will be a decrease in that value rather than an increase, the result being a corresponding increase in oscillator frequency rather than a decrease.

Also, although the tunable oscillator arrangement has been shown as being based around bipolar circuitry, it may in practice employ other technology, e.g. MOS devices. In addition, the distortion compensation afforded by the linearising arrangement of Figure 2 is not limited to the cancellation of a cubic non-linearity, but may be extended to the compensation of any order of non-linearity by an appropriate choice of ratios for the various currents and resistors in the circuit.

Below are listed the relative component values of a preferred realisation of the tunable oscillator arrangement of Figures 2 and 3:

$R_{165} = R_{166}$
$R_{67} = R_{68}$
$R_{83} = R_{165}$
$R_{160} = R_{161}$
$R_{108} = R_{162} = 4.88 R_{160}$
$I_{157} = I_{53} = I_{54} = I_{123} = I_{124}$
$I_{158} = 4.23 I_{157}$
$I_{159} = 1.41 I_{157}$
$I_{163} = I_{164} = I_{65} = I_{66} = I_{106} = I_{107} = I_{158}$

**Claims**

1. A tunable oscillator arrangement, comprising a frequency-determining means and a tuning amplifier, the frequency-determining means comprising a frequency-determining element which is connected between an input and an output of the tuning amplifier, whereby an operating frequency of the oscillator arrangement is adjustable by an adjustment of the gain of the tuning amplifier.

2. A tunable oscillator arrangement, as claimed in Claim 1, in which the frequency-determining element is a capacitor.

**3.** A tunable oscillator arrangement, as claimed in Claim 2, in which the tuning amplifier comprises a tuning differential amplifier stage with differential inputs and outputs, and the frequency-determining means comprises two capacitors, the capacitors being connected between separate inputs and outputs of the tuning differential amplifier stage.

**4.** A tunable oscillator arrangement, as claimed in Claim 3, in which the frequency-determining means comprises an inductive element which is coupled across the differential inputs of the tuning differential amplifier stage.

**5.** A tunable oscillator arrangement, as claimed in Claim 3 or Claim 4, including a negative impedance converter connected in series with a tail circuit of the tuning differential amplifier stage.

**6.** A tunable oscillator arrangement, as claimed in Claim 5, in which the negative impedance converter comprises two transistors cross-coupled from collector to base, a first resistive element being connected between the two emitters of the transistors, and the respective emitters and collectors of the transistors providing respective conduction paths for tail currents of respective halves of the tuning differential amplifier stage.

**7.** A tunable oscillator arrangement, as claimed in any one of Claims 3 to 6, in which a gain-adjusting means is included in an output circuit of the tuning differential amplifier stage.

**8.** A tunable oscillator arrangement, as claimed in Claim 7, in which the gain-adjusting means is arranged to steer output current from each half of the tuning differential amplifier stage into either or both of two tuning load-impedance elements, such as to provide a tuning amplifier gain of variable magnitude and sign, depending on a gain-control voltage applied to the gain-adjusting means.

**9.** A tunable oscillator arrangement, as claimed in Claim 8, in which the gain-adjusting means is a multiplier comprising two long-tailed pairs of transistors, the pairs of transistors being fed in parallel from differential gain-control inputs, the collectors of the two halves of one pair of transistors being connected respectively to the collectors of the oppositely fed halves of the other pair of transistors and to respective load-impedance elements, and the long-tailed pairs each having commoned emitters which serve to supply the output current of a respective half of the tuning differential amplifier stage.

**10.** A tunable oscillator arrangement, as claimed in Claim 9, in which the differential inputs of the multiplier are fed from respective differential outputs of a controlling differential amplifier stage, the outputs of the controlling differential amplifier stage being connected to respective diode elements which serve as controlling load-impedance elements, and the controlling differential amplifier stage having differential inputs for receiving the gain-control voltage.

**11.** A tunable oscillator arrangement, as claimed in Claim 9 or Claim 10, in which the tuning differential amplifier stage has differential outputs which are taken from the respective tuning load-impedance elements by way of respective voltage followers, the voltage followers providing a low-output-impedance drive for the capacitors of the frequency-determining means.

**12.** A tunable oscillator arrangement, as claimed in any one of the preceding claims, in which the frequency-determining means is part of an active oscillator stage.

**13.** A tunable oscillator arrangement, as claimed in Claim 4 and Claim 12, in which the active oscillator stage comprises an oscillator differential amplifier stage, the inductive element being coupled across differential inputs of the oscillator differential amplifier stage, and non-inverting outputs of the oscillator differential amplifier stage being connected to respective inputs of the tuning differential amplifier stage.

**14.** A tunable oscillator arrangement, as claimed in Claim 13, in which the oscillator differential amplifier stage comprises an oscillator long-tailed pair and a linearising means for substantially cancelling distortions which arise in the oscillator long-tailed pair.

**15.** A tunable oscillator arrangement, as claimed in Claim 14, in which the linearising means comprises first, second and third linearising bipolar-transistor long-tailed pairs, the collectors of respective halves of the linearising long-tailed pairs being connected together and to respective bases of the oscillator long-tailed pair, and the bases of each linearising long-tailed pair being connected to respective emitters of the oscillator long-tailed pair, such that the first and third linearising long-tailed pair are driven in phase with each other and in antiphase with the second linearising long-tailed pair.

16. A tunable oscillator arrangement, as claimed in Claim 15, in which the bases of the third linearising long-tailed pair are connected to each other by way of a second resistive element and to respective emitters of the oscillator long-tailed pair by way of third and fourth resistive elements, respectively.

17. A tunable oscillator arrangement, as claimed in Claim 16, in which the tail currents of the oscillator long-tailed pair and the respective tail currents of the first, second and third linearising long-tailed pairs are provided by respective current sources.

18. A tunable oscillator arrangement, as claimed in Claim 17, in which the linearising means is arranged to compensate for a cubic nonlinearity which arises due to an exponential nature of a base-emitter characteristic of the transistors of the oscillator long-tailed pair.

19. A tunable oscillator arrangement, as claimed in Claim 18, in which the third and fourth resistive elements are of substantially equal resistance value and are approximately 1/4.88 times the resistance value of the second resistive element, and the tail current provided by each of the oscillator long-tailed pair current sources and by the second linearising long-tailed pair current source is approximately equal to 4.23 times, and the tail current provided by the third linearising long-tailed pair current source approximately equal to 1.41 times, the tail current provided by the first linearising long-tailed pair current source.

20. A tunable oscillator arrangement, substantially as hereinbefore described with reference to the accompanying drawings.

**Figure 1**

**Figure 2**

Figure 3

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | IBM TECHNICAL DISCLOSURE BULL., vol. 5, no. 11, April 1963 pages 66-67, M.G. WILSON 'System for Varying Oscillator Frequency' * the whole document * --- | 1,2,12, 20 | H03B5/12 H03B5/20 H03B7/06 G06G7/186 H03F1/14 |
| X | US-A-5 004 989 (HASLER RUDOLF) 2 April 1991 * column 2, line 66 - column 5, line 20; figure 1 * --- | 1,2,12, 20 | |
| A | EP-A-0 404 080 (MATSUSHITA ELECTRIC IND CO LTD) 27 December 1990 * column 3, line 43 - column 6, line 8; figures 1-5 * --- | 3,4,11, 13,14 | |
| P,A | US-A-5 355 094 (SODA MASAAKI) 11 October 1994 * column 2, line 10-14 * * column 4, line 12 - column 5, line 30; figures 1,2 * --- | 3-6,13 | |
| A | GB-A-2 217 939 (PLESSEY CO PLC) 1 November 1989 * page 2, line 5 - page 4, line 23; figures 1-3 * --- | 5,6, 14-19 | TECHNICAL FIELDS SEARCHED (Int.Cl.6) H03B G06G H03F |
| A | US-A-4 621 238 (FENK JOSEF) 4 November 1986 * column 3, line 37 - column 7, line 58; figures 1,2 * --- | 7-10 | |

-/--

The present search report has been drawn up for all claims

| Place of search | Date of completion of the search | Examiner |
|---|---|---|
| MUNICH | 12 September 1995 | Zwicker, T |

EPO FORM 1503 03.82 (P04C01)

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | IBM TECHNICAL DISCLOSURE BULLETIN, vol. 10, no. 6, 1 November 1967 US, page 847 J.K. AYLING ET AL 'Simulated Inductive Components' * the whole document * | 1-20 | |

TECHNICAL FIELDS
SEARCHED      (Int.Cl.6)

The present search report has been drawn up for all claims

| Place of search | Date of completion of the search | Examiner |
|---|---|---|
| MUNICH | 12 September 1995 | Zwicker, T |

EPO FORM 1503 03.82 (P04C01)